# DEMANDE DE BREVET EUROPEEN

(11) **EP 2 290 691 A1**
(43) Date de publication de la demande: **02.03.2011**
(21) Numéro de dépôt: 10173297.2
(22) Date de dépôt: 18.08.2010
(51) Int. Cl.: H01L 27/02, H01L 29/74

(54) **Structure de protection d'un circuit intégré contre des décharges électrostatiques**

(30) Priorité: 24.08.2009 FR 0955757
(71) Demandeur: STmicroelectronics SA, 92120 Montrouge (FR)
(72) Inventeur: Galy, Philippe, 38660, LE TOUVET (FR); Entringer, Christophe, 38190, BRIGNOUD (FR); Jimenez, Jean, 38920, CROLLES (FR)
(74) Mandataire: de Beaumont, Michel

(57) **Abrégé**

L'invention concerne une structure de protection (21) d'un circuit intégré contre des décharges électrostatiques comprenant un dispositif d'évacuation de surtensions (15, 16, 17) entre des premier (5) et second (5) rails d'alimentation ; et une cellule de protection (31) reliée à un plot (3) du circuit comprenant une diode (23) dont une électrode liée à une région d'un premier type de conductivité est reliée au second rail d'alimentation (7) et dont une électrode liée à une région d'un second type de conductivité est reliée au plot (3), et, en parallèle avec la diode, un thyristor (25) dont une électrode liée à une région du premier type de conductivité est reliée au plot (3) et dont une gâchette liée à une région du second type de conductivité est reliée au premier rail (5), les premier et second types de conductivité étant tels que, en fonctionnement normal, lorsque le circuit est alimenté, la diode (23) est non passante.

## Description

### Domaine de l'invention

La présente invention concerne des structures de protection des circuits intégrés contre des décharges électrostatiques.

### Exposé de l'art antérieur

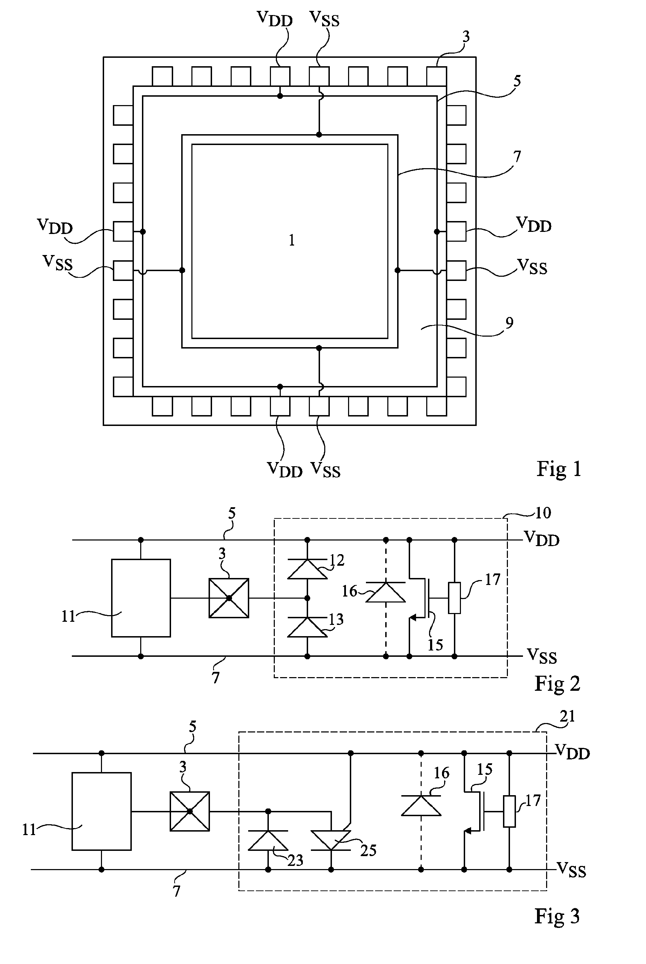

La figure 1 est une vue de dessus schématique d'une puce de circuit intégré. Le circuit intégré comprend une partie centrale 1 reliée à un ensemble de plots métalliques 3 disposés à la périphérie de la puce et destinés à assurer des connexions vers l'extérieur. La partie centrale 1 comprend l'ensemble des composants permettant au circuit intégré de remplir des fonctions souhaitées. Certains des plots 3 sont destinés à recevoir des potentiels d'alimentation positif (V_{DD}) et négatif (V_{SS}). Des rails d'alimentation positif 5 et négatif 7 sont généralement prévus tout autour du circuit. Les autres plots 3 sont notamment destinés à recevoir et/ou à fournir des signaux d'entrée-sortie. L'ensemble du circuit est recouvert d'une couche isolante ne laissant accessible que des bornes reliées aux plots 3, et est éventuellement mis dans un boîtier comprenant des cosses reliées aux plots 3 ou des billes liées à ces plots.

Un tel circuit reçoit et/ou fournit généralement des signaux à faible niveau de tension (par exemple 0,6 à 3 V) et à faible intensité de courant (par exemple 1 µA à 10 mA), et est susceptible d'être endommagé lorsque des surtensions ou des surintensités surviennent entre des bornes du boîtier. Des surtensions peuvent survenir, pendant la phase de fabrication ou d'assemblage, avant le montage du circuit dans un dispositif (par exemple sur une carte de circuit imprimé), lors de décharges électrostatiques liées à la manipulation des circuits par des outils ou à la main. Ces surtensions peuvent atteindre plusieurs milliers de volts et détruire des éléments du circuit.

On prévoit donc d'associer à chaque plot 3 une structure de protection qui occupe généralement une couronne 9 disposée entre les plots 3 et la partie centrale 1 de la puce. La structure de protection doit être capable d'évacuer rapidement des courants importants, susceptibles d'apparaître lorsqu'une décharge électrostatique survient entre deux plots ou deux bornes du boîtier, et en cas de surtension sur une borne d'un dispositif connecté à un circuit.

La figure 2 représente le schéma électrique d'un exemple de structure de protection 10, associée à un plot d'entrée-sortie 3 d'un circuit intégré. Un bloc 11 relié au plot 3 et aux rails d'alimentation positif 5 et négatif 7, représente de façon schématique des éléments de circuit, protégés par la structure 10 contre d'éventuelles décharges électrostatiques.

Une diode 12 est connectée en direct entre le plot 3 et le rail d'alimentation positif 5. Une diode 13 est connectée en inverse entre le plot 3 et le rail d'alimentation négatif 7. Un transistor MOS 15, utilisé comme interrupteur, est connecté entre les rails 5 et 7. Un circuit 17 de détection de surtension, connecté parallèlement au transistor MOS 15, fournit un signal de déclenchement à ce transistor. Le circuit 17 de détection de surtension pourra par exemple être un détecteur de front comprenant une résistance en série avec un condensateur, le noeud de connexion entre la résistance et le condensateur changeant d'état en cas de surtension brutale. Le transistor MOS 15 comporte notamment une diode parasite 16 connectée en direct entre le rail 7 et le rail 5.

On indiquera ci-après le fonctionnement de la structure de protection 10 en cas de surtension survenant sur un plot d'entrée-sortie (on parlera simplement de "plot") ou sur un plot relié à un rail d'alimentation (on parlera simplement de "rail").

En fonctionnement normal, lorsque la puce est alimentée, c'est-à-dire que le rail 5 est positif par rapport au rail 7 et que les plots d'entrée-sortie sont à un niveau intermédiaire, les diodes 12 et 13 sont toutes deux polarisées en inverse et ne laissent pas passer de courant. De plus, le circuit de détection 17 rend le transistor MOS 15 non passant.

En cas de surtension positive entre les rails d'alimentation positif 5 et négatif 7, le circuit 17 rend le transistor 15 passant, ce qui permet l'évacuation de la surtension.

En cas de surtension négative entre les rails 5 et 7, la diode parasite 16 du transistor 15 devient passante et la surtension est évacuée.

En cas de surtension positive entre un plot 3 et le rail positif 5, la diode 12 devient passante et la surtension est évacuée.

En cas de surtension négative entre un plot 3 et le rail 5, le circuit 17 rend le transistor 15 passant, et la surtension est évacuée par le transistor 15 et la diode 13.

En cas de surtension positive entre un plot 3 et le rail négatif 7, la diode 12 devient passante et la surtension positive est reportée sur le rail 5, ce qui correspond au cas traité ci-dessus d'une surtension positive les rails 5 et 7.

En cas de surtension négative entre un plot 3 et le rail d'alimentation négatif 7, la diode 13 devient passante et la surtension est évacuée.

En cas de surtension entre deux plots 3, la diode 12 associée au plot le plus positif devient passante, et la surtension est reportée sur le rail positif 5. Cela correspond au cas traité ci-dessus d'une surtension négative entre un plot 3 (le plus négatif) et le rail 5.

Un inconvénient d'une telle structure de protection réside dans le fait que les diodes 12 et 13 présentent des capacités parasites importantes. En fonctionnement normal, les caractéristiques des signaux d'entrée-sortie du circuit sont dégradées par ces capacités parasites.

En outre, pour pouvoir évacuer les courants induits par des décharges électrostatiques, les diodes 12 et 13 doivent avoir une surface importante (typiquement, un périmètre de jonction de 200 µm par diode). Il en résulte que la couronne 9 (figure 1) occupe une surface de silicium importante, au détriment de la partie centrale 1 de la puce.

Par ailleurs, les diodes 12 et 13 sont des composants distincts, ce qui rend la fabrication de la couronne 9 complexe. Les composants distincts doivent en outre être isolés les uns des autres, ce qui augmente la surface totale de silicium d'un circuit intégré.

### Résumé

Ainsi, un objet d'un mode de réalisation de la présente invention est de proposer une structure de protection contre des décharges électrostatiques palliant tout ou partie des inconvénients des structures de protection classiques.

Un objet d'un mode de réalisation de la présente invention est de proposer une structure de protection contre des décharges électrostatiques présentant une capacité parasite réduite.

Un objet d'un mode de réalisation de la présente invention est de proposer une telle structure occupant une faible surface de silicium.

Un objet d'un mode de réalisation de la présente invention est de proposer une telle structure facile à réaliser.

Ainsi, un mode de réalisation de la présente invention prévoit une structure de protection d'un circuit intégré contre des décharges électrostatiques comprenant un dispositif d'évacuation de surtensions entre des premier et second rails d'alimentation ; et une cellule de protection reliée à un plot du circuit comprenant une diode dont une électrode liée à une région d'un premier type de conductivité est reliée au second rail d'alimentation et dont une électrode liée à une région d'un second type de conductivité est reliée au plot, et, en parallèle avec la diode, un thyristor dont une électrode liée à une région du premier type de conductivité est reliée au plot et dont une gâchette liée à une région du second type de conductivité est reliée au premier rail, les premier et second types de conductivité étant tels que, en fonctionnement normal, lorsque le circuit est alimenté, la diode est non passante.

Selon un mode de réalisation de la présente invention, la cellule de protection comprend des première à cinquième régions de types de conductivité alternés ayant, en vue de dessus, la forme d'anneaux concentriques de diamètres respectifs croissants, dans laquelle les première à troisième régions sont formées dans un caisson central du premier type de conductivité ; la première région est du second type de conductivité ; les quatrième et cinquième régions sont formées dans un caisson périphérique du second type de conductivité ; et les première et quatrième régions sont reliées audit plot, les deuxième et troisième régions sont reliées au second rail d'alimentation, et la cinquième région est reliée au premier rail d'alimentation.

Selon un mode de réalisation de la présente invention, les premier et second types de conductivité correspondent respectivement à un dopage de type P et à un dopage de type N, et, en fonctionnement normal, le premier rail d'alimentation est plus positif que le second rail d'alimentation.

Selon un mode de réalisation de la présente invention, les premier et second types de conductivité correspondent respectivement à un dopage de type N et à un dopage de type P, et, en fonctionnement normal, le second rail d'alimentation est plus positif que le premier rail d'alimentation.

Selon un mode de réalisation de la présente invention, lesdites régions sont isolées les unes des autres par des régions d'oxyde de silicium.

Selon un mode de réalisation de la présente invention, le dispositif d'évacuation de surtensions entre des premier et second rails d'alimentation comporte un transistor MOS dont les première et seconde bornes de conduction sont respectivement reliées aux premier et second rails d'alimentation, et, entre les rails d'alimentation, un détecteur de surtensions dont la sortie commande le transistor MOS.

Selon un mode de réalisation de la présente invention, le détecteur de surtensions comprend une résistance en série avec un condensateur, le noeud de connexion entre la résistance et le condensateur étant relié à la grille du transistor MOS.

Selon un mode de réalisation de la présente invention, lesdits anneaux sont à contours carrés ou rectangulaires.

Selon un mode de réalisation de la présente invention, la première région a la forme d'un anneau plein.

Selon un mode de réalisation de la présente invention, la première région a la forme d'un anneau à partie centrale évidée.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue de dessus schématique d'une puce de circuit intégré ;
la figure 2, précédemment décrite, représente le schéma électrique d'un exemple de structure de protection contre les surtensions, associée à un plot d'un circuit intégré ;
la figure 3 représente le schéma électrique d'un exemple de réalisation d'une structure de protection contre les surtensions associée à un plot d'un circuit intégré ;
la figure 4A est une vue en coupe représentant de façon schématique un exemple de réalisation d'une partie de la structure de protection décrite en relation avec la figure 3 ;
la figure 4B est une vue de dessus de la figure 4A ;
la figure 5 est une vue en coupe dans le même plan que la figure 4A, représentant une variante de réalisation d'une partie de la structure décrite en relation avec la figure 3 ;
la figure 6 représente le schéma électrique d'une variante de réalisation de la structure de la figure 3 ; et
la figure 7 est une vue en coupe dans le même plan que la figure 4A représentant un exemple de réalisation d'une partie de la structure décrite en relation avec la figure 6.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

La figure 3 représente le schéma électrique d'un exemple de structure de protection contre les surtensions 21, associée à un plot d'entrée-sortie 3 d'un circuit intégré. Un bloc 11 relié au plot 3 et aux rails d'alimentation positif 5 et négatif 7, représente de façon schématique des éléments de circuit, protégés par la structure 21 contre d'éventuelles décharges électrostatiques.

De même que la structure de protection 10 décrite en relation avec la figure 2, la structure 21 comprend un transistor MOS 15, utilisé comme interrupteur, connecté entre les rails 5 et 7. Un circuit 17 de détection de surtension, connecté parallèlement au transistor MOS 15, fournit un signal de déclenchement à ce transistor. Le transistor MOS 15 comporte notamment une diode parasite 16 connectée en direct entre le rail 7 et le rail 5.

Une diode 23 est connectée en inverse entre le plot 3 et le rail négatif 7. Un thyristor 25 est connecté en direct entre le plot 3 et le rail 7. La gâchette d'anode du thyristor 25 est reliée au rail positif 5.

En fonctionnement normal, c'est-à-dire lorsque la puce est alimentée, les signaux sur le plot 3 et les rails 5 et 7 sont tels que la diode 23 ne laisse pas passer de courant et le circuit de détection 17 rend le transistor MOS 15 non passant. La gâchette d'anode du thyristor 25 est plus positive que son anode et ce thyristor reste donc ouvert.

En cas de surtension positive entre les rails 5 et 7, le circuit 17 rend le transistor 15 passant, ce qui permet l'évacuation de la surtension.

En cas de surtension négative entre les rails 5 et 7, la diode parasite 16 du transistor 15 devient passante et la surtension est évacuée.

En cas de surtension positive entre un plot 3 et le rail 5, il circule un courant entre le plot 3 et le rail 5, passant par l'anode et la gâchette d'anode du thyristor 25. Ce courant provoque la fermeture du thyristor 25, et la surtension est évacuée par le thyristor 25 et la diode 16.

En cas de surtension négative entre un plot 3 et le rail 5, le circuit 17 rend le transistor 15 passant, et la surtension est évacuée par le transistor 15 et la diode 23.

En cas de surtension positive entre un plot 3 et le rail 7, l'anode du thyristor 25 est positive par rapport à sa gâchette d'anode. Une partie de la surtension est donc reportée sur le rail 5, et le circuit 17 rend le transistor MOS 15 passant. Il existe donc un chemin de conduction entre le plot 3 et le rail 7, passant par l'anode et la gâchette d'anode du thyristor 25, et par le transistor MOS 15. Ce courant entraine la fermeture du thyristor 25, qui évacue alors la surtension.

En cas de surtension négative entre un plot 3 et le rail 7, la diode 23 devient passante et évacue la surtension.

Pour l'explication de l'élimination d'une surtension entre deux plots d'entrée-sortie, on appellera plot positif le plot recevant le potentiel le plus élevé et plot négatif le plot recevant le potentiel le plus faible. En cas de surtension entre plots, il circule un courant entre l'anode et la gâchette d'anode du thyristor 25 associé au plot positif. Une partie de la surtension est donc reportée sur le rail 5, et le circuit 17 rend le transistor MOS 15 passant. Il existe donc un chemin de conduction entre le plot positif et le plot négatif, passant par l'anode et la gâchette d'anode du thyristor 25 associé au plot positif, par le transistor MOS 15, et par la diode 23 associée au plot négatif. Ce courant entraine la fermeture du thyristor 25. La surtension est alors évacuée par le thyristor 25 associé au plot positif et par la diode 23 associée au plot négatif.

La structure de protection 21 permet donc d'évacuer tous les types de surtension pouvant survenir entre plots et/ou rails du circuit par suite d'une décharge électrostatique.

Un avantage de la structure 21 réside dans le fait que l'une des deux diodes des structures de protection classiques est remplacée par un thyristor. Or, à possibilité d'évacuation de courant égale, un thyristor présente une capacité parasite au moins deux fois moins importante que celle d'une diode. La structure de protection 21 présente donc une capacité parasite réduite par rapport à la structure à deux diodes de la figure 2.

De plus, à possibilité d'évacuation de courant égale, un thyristor aura une plus faible surface qu'une diode en raison de sa plus faible chute de tension à l'état passant.

Pour réduire encore la surface de la structure de protection, on prévoit un mode d'intégration particulier du thyristor 25 et de la diode 23 d'une structure de protection.

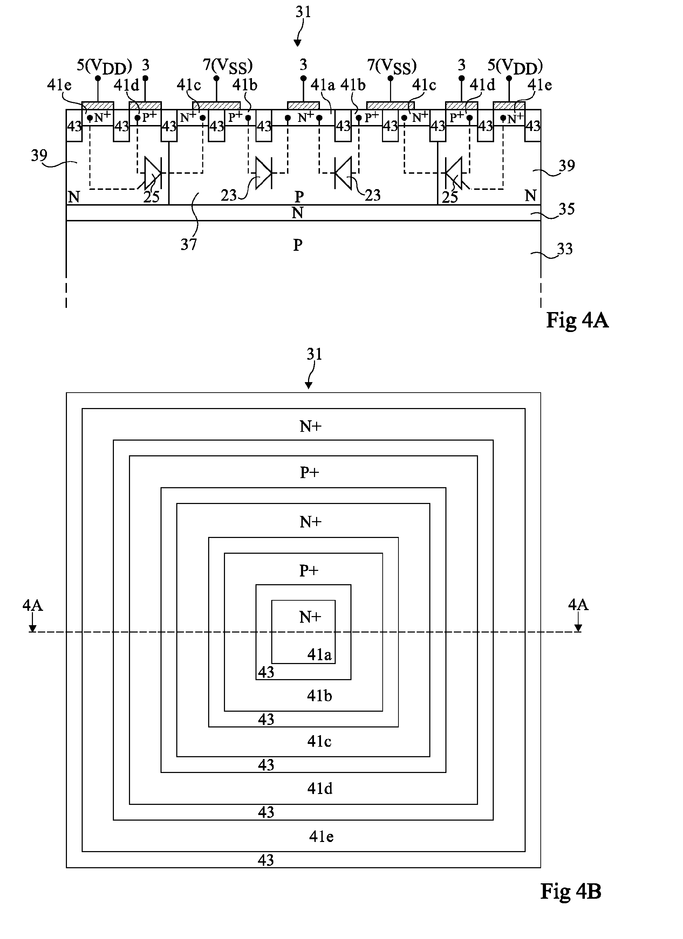

La figure 4A est une vue en coupe représentant de façon schématique un exemple de réalisation d'une cellule de protection 31 comprenant le thyristor 25 et la diode 23 de la structure de protection 21 décrite en relation avec la figure 3.

La figure 4B est une vue de dessus de la figure 4A.

A titre d'exemple, on se place ici dans le cadre d'une technologie CMOS, permettant notamment de réaliser des transistors MOS à canal N dans des caissons dopés de type P, et des transistors MOS à canal P dans des caissons dopés de type N. Les caissons N et P sont généralement formés dans une couche 35 de type N, reposant sur un substrat 33 dopé de type P. A titre d'exemple, le niveau de dopage du substrat 33 est de l'ordre de 10¹⁴ à 10¹⁵ atomes/cm³, le niveau de dopage de la couche 35 est de l'ordre de 10¹⁸ atomes/cm³, et le niveau de dopage des caissons N et P est de l'ordre de 10¹⁶ à 10¹⁷ atomes/cm³.

Un caisson central 37 dopé de type P est formé dans la partie supérieure de la couche 35. Le caisson 37 est entouré d'un caisson périphérique 39 dopé de type N, qui s'étend à partir de la périphérie du caisson central. En vue de dessus, le caisson 39 a la forme d'un anneau dont le contour intérieur est en contact avec le contour extérieur du caisson central 37.

Dans la partie supérieure des caissons 37 et 39, il est prévu cinq régions fortement dopées 41a à 41e, de types de conductivité alternés, ayant, en vue de dessus, c'est à dire dans un plan parallèle aux faces principales du substrat, la forme d'anneaux concentriques de diamètres respectifs croissants. Dans l'exemple représenté, les anneaux ont des contours carrés, et l'anneau 41a de plus petit diamètre est un anneau plein.

Les anneaux 41a à 41c sont formés dans le caisson central 37, et l'anneau de plus petit diamètre 41a est de type de conductivité opposé à celui du caisson 37, c'est-à-dire de type N dans cet exemple. Les anneaux 41d et 41e sont formés dans le caisson périphérique 39.

A titre d'exemple, le niveau de dopage des régions 41a, 41c et 41e, de type N, est de l'ordre de 10¹⁹ à 10²¹ atomes/cm³, et le niveau de dopage des régions 41b et 41d, de type P, est de l'ordre de 10¹⁸ à 10²⁰ atomes/cm³, ce qui correspond, en technologie CMOS, aux niveaux de dopage des régions de source et de drain des transistor MOS.

Dans cet exemple, les régions 41a à 41e sont isolées les unes des autres par des rainures 43 remplies d'oxyde de silicium (STI).

La région 41e est reliée au rail d'alimentation positif 5. Les régions 41d et 41a sont reliées à un plot d'entrée-sortie 3 du circuit. Les régions 41c et 41b sont reliées au rail d'alimentation négatif 7. A titre d'exemple, les connexions susmentionnées comprennent des métallisations, représentées en figure 4A par des zones hachurées, formant des contacts ohmiques avec les régions fortement dopées 41a à 41e.

Comme l'illustre de façon schématique la figure 4A, la cellule de protection 31 constitue, entre le plot 3 et les rails d'alimentation 5 et 7, une diode 23 et un thyristor 25, connectés de la façon décrite en relation avec la figure 3.

Entre le plot 3 et le rail 7, on trouve le thyristor 25, correspondant aux régions PNPN 41d-39-37-41c. La gâchette d'anode de ce thyristor, correspondant à la région 41e, est reliée au rail 5. Entre le plot 3 et le rail 7, on trouve la diode 23, correspondant aux régions N⁺PP⁺ 41b-37-41a.

Selon un avantage du mode de réalisation décrit ci-dessus, la diode 23 et le thyristor 25 sont intégrés dans une unique cellule de protection 31. Ainsi, la surface de silicium utile à l'évacuation des surtensions est optimisée par rapport aux structures comprenant deux diodes distinctes (figure 2) devant être isolées l'une de l'autre. A titre d'exemple, à possibilité d'évacuation de surtensions équivalente, la cellule 31 occupe une surface environ six fois moins importante que les deux diodes d'une structure classique.

Selon un autre avantage d'une telle intégration en anneaux concentriques, la surface des métallisations de contact entre la diode 23 et le thyristor 25 est faible par rapport à une structure de protection constituée uniquement de composants discrets. Ceci permet de limiter les capacités parasites liées à la protection. En particulier, dans la cellule proposée, une unique métallisation de contact commune est prévue pour l'anode de la diode 23 et pour la cathode du thyristor 25. A titre d'exemple, dans les solutions usuelles, du fait des capacités parasites liées aux structures de protection, la fréquence des signaux utiles émis et/ou reçus sur les plots du circuit à protéger ne doit pas dépasser 10 GHz. Les essais menés par les inventeurs ont montré que la structure de protection proposée peut être associée à des circuits dont des plots émettent et/ou reçoivent des signaux utiles de fréquence pouvant atteindre 20 GHz.

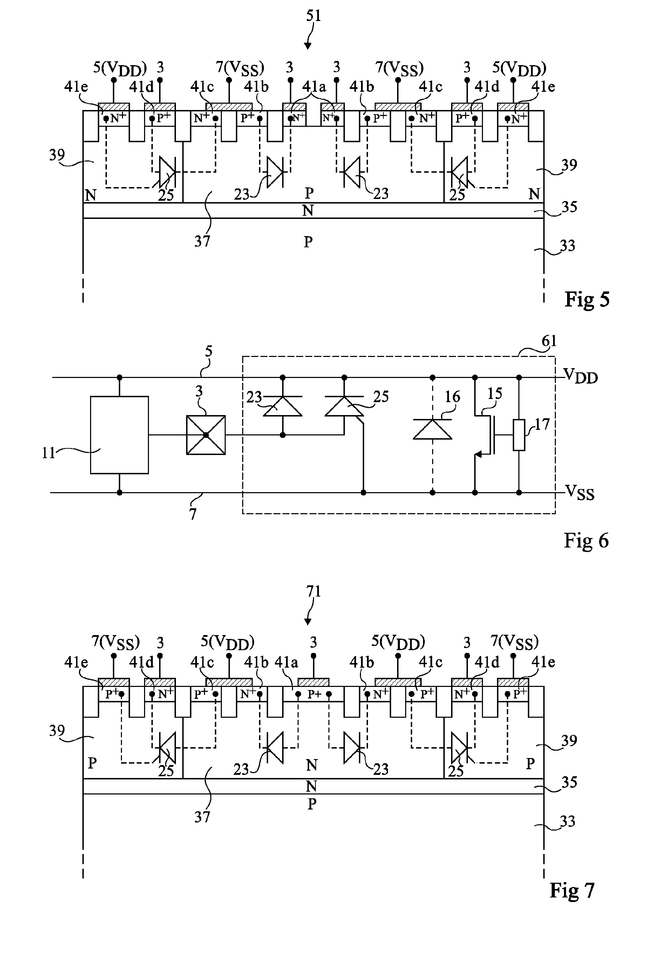

La figure 5 est une vue en coupe dans le même plan que la figure 4A représentant une variante de réalisation d'une cellule de protection 51 comprenant le thyristor 25 et la diode 23 de la structure 21 décrite en relation avec la figure 3.

La cellule de protection 51 est identique à la cellule de protection 31 décrite en relation avec les figures 4A et 4B, à la différence que la région fortement dopée 41a, de plus petit diamètre, a, en vue de dessus, la forme d'un anneau à partie centrale évidée, et non pas d'un anneau plein, ce qui réduit la capacité parasite de la diode 23.

A titre d'exemple, à possibilité d'évacuation de surtensions équivalente, la cellule 51 présente une capacité parasite environ deux fois plus faible que celle présentée par les deux diodes de la figure 2.

La figure 6 représente le schéma électrique d'une variante de réalisation 61 de la structure de protection 21 décrite en relation avec la figure 3. La structure 61 comprend les mêmes composants que la structure 21 avec une inversion de polarités. Dans la structure 61, la diode 23 est connectée en direct entre le plot 3 et le rail positif 5. De plus, le thyristor 25 est connecté en direct entre le rail positif 5 et le plot 3, et la gâchette de cathode (et non d'anode) du thyristor 25 est reliée au rail négatif 7.

De même que la structure de protection 21, la structure 61 permet d'évacuer tous les types de surtension pouvant survenir entre plots et/ou rails du circuit par suite d'une décharge électrostatique.

La figure 7 est une vue en coupe dans le même plan que la figure 4A représentant de façon schématique un exemple de réalisation d'une cellule de protection 71 comprenant le thyristor 25 et la diode 23 de la structure de protection 61 décrite en relation avec la figure 6.

La cellule de protection 71 est identique à la cellule de protection 31 décrite en relation avec les figures 4A et 4B, à la différence près que les types de conductivité des régions 41a à 41e et des caissons 37 et 39 ont été inversés. En outre, les connexions aux rails positif 5 et négatif 7 ont été permutées.

Selon un avantage de la présente invention, les cellules de protection proposées ci-dessus peuvent être réalisées selon des procédés de fabrication traditionnels, par exemple dans le cadre d'une technologie CMOS, et ne nécessitent aucune étape supplémentaire par rapport à ces procédés.

Des modes de réalisation particuliers de la présente invention ont été décrits. Diverses variantes et modifications apparaîtront à l'homme de l'art. En particulier, on a mentionné dans la description ci-dessus des potentiels positif et négatif. Il est bien sur entendu que le terme "positif" désigne des valeurs supérieures aux valeurs désignées par le terme "négatif" et inversement. Bien souvent, le potentiel négatif sera la masse.

De plus, on décrit en relation avec les figures 4A, 4B, 5 et 7 des modes de réalisation de cellules de protection 31, 51 et 71 comportant des régions fortement dopées ayant, en vue de dessus, la forme d'anneaux concentriques à contours carrés. L'invention ne se limite pas à cette forme particulière. Toute autre forme de contour fermé pourra être utilisée.

Par ailleurs, dans les exemples de réalisation décrits ci-dessus, les régions en anneaux concentriques sont isolées les unes des autres par de l'oxyde de silicium. Certaines des couches d'isolation représentées sont optionnelles. On pourra par exemple se passer de l'isolation prévue entre les anneaux 41b et 41c (figures 4A, 4B, 5 et 7). On pourra également prévoir d'autres modes d'isolement.

En outre, des valeurs des niveaux de dopage des différentes régions semiconductrices constituant les cellules de protection ont été proposées. Ces valeurs sont fournies uniquement à titre d'exemple et ne sont pas limitatives. Elles ont été données dans le cadre d'une technologie CMOS particulière et seront facilement adaptées par l'homme de l'art à d'autres processus technologiques.

## Revendications

1. Cellule de protection (31 ; 51 ; 71) d'un circuit intégré contre des décharges électrostatiques reliée à un plot (3) et à des premier (5 ; 7) et second (7 ; 5) rails d'alimentation du circuit, comprenant une diode (23) dont une électrode liée à une région d'un premier type de conductivité est reliée au second rail d'alimentation (7 ; 5) et dont une électrode liée à une région d'un second type de conductivité est reliée au plot (3), et, en parallèle avec la diode, un thyristor (25) dont une électrode liée à une région du premier type de conductivité est reliée au plot (3) et dont une gâchette liée à une région du second type de conductivité est reliée au premier rail (5 ; 7), les premier et second types de conductivité étant tels que, en fonctionnement normal, lorsque le circuit est alimenté, la diode (23) est non passante, cette cellule comprenant des première à cinquième régions (41a à 41e) de types de conductivité alternés ayant, en vue de dessus, la forme d'anneaux concentriques de diamètres respectifs croissants, dans laquelle :
les première à troisième régions (41a à 41c) sont formées dans un caisson central (37) du premier type de conductivité ;
la première région (41a) est du second type de conductivité ;
les quatrième (41d) et cinquième (41e) régions sont formées dans un caisson périphérique (39) du second type de conductivité ; et
les première (41a) et quatrième (41d) régions sont reliées audit plot (3), les deuxième (41b) et troisième (41c) régions sont reliées au second rail d'alimentation (7 ; 5), et la cinquième région (41e) est reliée au premier rail d'alimentation (5 ; 7).

2. Cellule selon la revendication 1, dans laquelle les premier et second types de conductivité correspondent respectivement à un dopage de type P et à un dopage de type N, et, en fonctionnement normal, le premier rail d'alimentation (5) est plus positif que le second rail d'alimentation (7).

3. Cellule selon la revendication 1, dans laquelle les premier et second types de conductivité correspondent respectivement à un dopage de type N et à un dopage de type P, et, en fonctionnement normal, le second rail d'alimentation (5) est plus positif que le premier rail d'alimentation (7).

4. Cellule selon l'une quelconque des revendications 1 à 3, dans laquelle lesdites régions sont isolées les unes des autres par des régions d'oxyde de silicium (43).

5. Cellule selon l'une quelconque des revendications 1 à 4, dans laquelle lesdits anneaux sont à contours carrés ou rectangulaires.

6. Cellule selon l'une quelconque des revendications 1 à 5, dans laquelle ladite première région (41a) a la forme d'un anneau plein.

7. Cellule selon l'une quelconque des revendications 1 à 6, dans laquelle ladite première région (41a) a la forme d'un anneau à partie centrale évidée.

8. Structure de protection comprenant une cellule selon l'une quelconque des revendications 1 à 7, et un dispositif d'évacuation de surtensions (15, 16, 17) entre les premier et second rails d'alimentation.

9. Structure selon la revendication 8, dans laquelle ledit dispositif d'évacuation de surtensions (15, 16, 17) entre des premier et second rails d'alimentation comporte un transistor MOS (15) dont les première et seconde bornes de conduction sont respectivement reliées aux premier et second rails d'alimentation, et, entre les rails d'alimentation, un détecteur de surtensions (17) dont la sortie commande le transistor MOS (15).

10. Structure selon la revendication 9, dans laquelle le détecteur de surtensions (17) comprend une résistance en série avec un condensateur, le noeud de connexion entre la résistance et le condensateur étant relié à la grille du transistor MOS.
